# EUROPEAN PATENT APPLICATION

(11) **EP 2 093 613 A1**
(43) Date of publication of application: **26.08.2009**
(21) Application number: 07831900.1
(22) Date of filing: 15.11.2007
(51) Int. Cl.: G03F 7/11, G02B 1/11, H01L 21/027

(54) **COMPOSITION FOR UPPER SURFACE ANTIREFLECTION FILM, AND METHOD FOR PATTERN FORMATION USING THE SAME**

(30) Priority: 16.11.2006 JP 2006310529
(71) Applicant: AZ Electronic Materials USA Corp., Somerville, NJ 08876 (US)
(72) Inventor: NOYA, Go, Kakegawa-shi Shizuoka 437-1412 (JP); KOBAYASHI, Masakazu, Kakegawa-shi Shizuoka 437-1412 (JP); AKIYAMA, Yasushi, Kakegawa-shi Shizuoka 437-1412 (JP); KURAMOTO, Katsutoshi, Saitama 3320011 (JP)
(74) Representative: Rippel, Hans Christoph
(86) International application number: PCT/JP2007/072170
(87) International publication number: WO 2008/059918

(57) **Abstract**

The present invention provides a composition for forming a top anti-reflection coating and also provides a pattern formation method employing that composition. The composition prevents pattern failures caused by light reflected in the resist layer in the exposure step, and it further avoids troubles caused by residues produced in the etching step. The composition contains a solvent and fine particles having a mean particle size of 1 to 100 nm. In the pattern formation method of the present invention, a top anti-reflection coating is formed from the composition. The composition and the method according to the present invention can be used to form a composite film composed of a resist layer and a top anti-reflection coating.

## Description

### TECHNICAL FIELD

The present invention relates to a composition for top anti-reflection coating. More specifically, this invention relates to a composition for forming an anti-reflection coating, which is provided on the top surface of a resist layer when the resist layer is exposed to light in a photolithographic process for manufacturing semiconductor devices, flat panel displays (FPDs) such as liquid crystal displays, charge-coupled devices (CCDs), color filters and the like. This invention also relates to a pattern formation method using the composition for top anti-reflection coating.

### BACKGROUD ART

Photolithography has hitherto been used in the manufacture of semiconductor devices, FPDs such as liquid crystal displays, CCDs, color filters and the like. For example, in a photolithographic process for manufacturing integrated circuit devices, first a substrate is coated with a positive- or negative-working resist, and then baked to remove the solvent. Thereafter, the formed resist layer is exposed to radiations such as ultraviolet rays, far ultraviolet rays, electron beams and X-rays, and finally developed to form a resist pattern.

However, light having passed through the resist layer is reflected by the substrate and further the reflected light is again reflected by the upper layer of the resist layer. The again-reflected light reenters the resist layer to cause interference, and consequently the resultant resist pattern often differs from the designed one in dimensions such as line width and hole size. This problem is particularly serious if the substrate has a higher reflectance.

In order to solve the above problem, there have been studied and proposed various methods. For example, it is proposed that dyes having absorption in the wavelength range of light for exposure be dispersed in the resist. It is also proposed to provide a bottom anti-reflection coating (BARC) or a top anti-reflection coating. Further, a top surface imaging (TSI) method and a multilayer resist (MLR) method have been studied and proposed. Among them, the method employing a bottom anti-reflection coating is most widely used at present. As for the bottom anti-reflection coating, the inorganic coating and the organic one are both known. The inorganic coating is known to be formed from inorganic or metal materials by CVD (chemical vapor deposition), vapor deposition or sputtering. On the other hand, it is also known that the organic coating can be obtained by coating a substrate with an organic polymer solution containing dyes dissolved or dispersed therein or with a solution or dispersion of a polymer dye comprising chromophores combined chemically with the polymer.

Besides the above, it is also known to provide a top anti-reflection coating, which can be obtained by coating the upper surface of the resist layer with a film-forming composition containing a polymer and so on. The top anti-reflection coating reduces interference of light in the resist layer and thereby prevents variation of the pattern width, which is caused by variation of the resist thickness and the like, so that the aimed pattern can be obtained. Accordingly, the top anti-reflection coating is required to have a low refractive index and a high transmittance.

However, it is conventionally difficult to produce a top anti-reflection coating having a sufficiently low refractive index, and therefore there is room for improvement in the top anti-reflection coating.

### DISCLOSURE OF INVENTION

### PROBLEM TO BE SOLVED BY THE INVENTION

It is an object of the present invention to solve the above problem and to provide a composition capable of forming a top anti-reflection coating that makes it possible to produce finally an aimed pattern with sufficient precision.

### MEANS FOR SOLVING PROBLEM

The present invention resides in a composition for forming a top anti-reflection coating, characterized by comprising fine particles having a mean particle size of 1 to 100 nm and a solvent.

The present invention also resides in a pattern formation method comprising the steps of:
coating a substrate with a resist composition to form a resist layer,
spreading on said resist layer a composition for forming a top anti-reflection coating, said composition comprising fine particles having a mean particle size of 1 to 100 nm and a solvent; and then drying the spread composition,
imagewise exposing said resist layer to light, and
developing the resist layer.

The present invention further resides in a composite film comprising a resist layer and a top anti-reflection coating with which the top surface of said resist layer is covered, wherein said top anti-reflection coating contains fine particles having a mean particle size of 1 to 100 nm in an amount of 60 to 100 wt.% based on the total weight of said top anti-reflection coating.

### EFFECT OF THE INVENTION

The present invention makes it possible to form a top anti-reflection coating having such a low refractive index as 1.4 or less at 193 nm, which has been difficult to realize by conventional technology. This top anti-reflection coating reduces diffuse reflection of light in the resist layer when the layer is subjected to the exposure step of a photolithographic process.

### BEST MODE FOR CARRYING OUT THE INVENTION

The composition of the present invention for forming a top anti-reflection coating comprises fine particles having a mean particle size of 1 to 100 nm and a solvent. There is no particular restriction on the material of the fine particles as long as they have a mean particle size in the above range, and hence they may be organic particles or inorganic ones. Examples of the material include carbon, silicon dioxide, titanium dioxide, silicon nitride and alumina. In consideration of treatability and availability, fine carbon particles or fine silicon dioxide particles are preferred.

Here the term "fine carbon particles" means fine particles essentially made of carbon material only. Depending on bonds among the atoms in the material, there are various types of carbon material. However, the fine carbon particles used in the present invention may be made of any type of carbon material. Examples of the carbon material include:
naturally or artificially produced carbon materials such as carbon black, graphite and diamond, and only artificially produced carbon materials such as fullerene and carbon nanotubes.

As for the fine silicon dioxide particles, various kinds of silica particles such as colloidal silica, fumed silica and others which are different from each other in production process and in characteristics are known.Any of them can be used in the present invention.

The fine particles usable in the present invention has a mean particle size of 1 to 100 nm, preferably 5 to 70 nm, more preferably 10 to 50 nm. Here the mean particle size is determined by dynamic light scattering, and it can be measured concretely by means of a particle size analyzer (FPAR-1000 [tradename], manufactured by Otsuka Electronics Co., Ltd.).

The top anti-reflection coating obtained from the composition of the present invention mainly comprises the fine particles. However, in the anti-reflection coating, voids are also formed depending on the shapes of the fine particles. These voids lower the refractive index to give the effect of the present invention.

Although the fine particles have a mean size of 1 to 100 nm, particles smaller than them should be used in the case where a pattern having lines and holes in smaller dimensions is intended to be produced. It should be noted that, if the fine particles have a large mean size, the resultant pattern is liable to deteriorate in roughness.

The composition for forming a top anti-reflection coating contains the fine particles in an amount of preferably 60 to 100 wt.%, more preferably 75 to 100 wt.%, further preferably 80 to 100 wt.%, based on the solid content of the composition. If the amount of the fine particles is less than the above range, the aforementioned voids are not properly formed among the particles and accordingly the effect of the present invention is often impaired. This should be noted.

The composition of the present invention for forming a top anti-reflection coating contains a solvent as well as the above fine particles. Although water is generally used as the solvent, a small amount of organic solvent can be used as a co-solvent for improving characteristics such as wettability. Examples of the organic solvent include alcohols such as methanol and ethanol, ketones such as acetone and methyl ethyl ketone, and esters such as ethyl acetate. The solvent should be so selected that the composition neither dissolves nor denaturalizes the resist layer, on which the composition is applied.

The composition of the present invention for forming a top anti-reflection coating may further contain a water-soluble polymer, preferably a fluorinated polymer or an acrylic polymer, and/or a surfactant such as a fluorinated surfactant. These components are used mainly for the purpose of improving coatability of the composition onto the resist layer, rather than for the purpose of constituting the top anti-reflection coating. These additives are, therefore, incorporated normally in smaller amounts than the aforementioned fine particles.

In the case where the composition of the present invention contains a water-soluble polymer, the polymer is, for example, a fluorinated polymer which has carboxyl at the terminal and which is represented by the formula:

-(CF₂CFR)ₙ-

(in which R is a straight-chain fluorine-substituted alkyl group, and n is a number indicating the polymerization degree). Further, acrylic polymers such as polyacrylic acid, vinyl pyrrolidone, polyvinyl alcohol and the like are also usable. In the case where the composition contains a surfactant, the surfactant is, for example, an anionic surfactant such as di(2-ethylhexyl)sulfosuccinic acid or an alkylsulfonic acid having an alkyl chain of 13 to 18 carbon atoms; a cationic surfactant such as hexadecyltrimethylammonium hydroxide; or a nonionic surfactant such as a copolymer of polyethylene oxide and propylene oxide.

According to necessity, the composition of the present invention for forming a top anti-reflection coating is so prepared that it has an adequate solid content. Normally, the top anti-reflection coating is preferably formed in a thickness proper to sufficiently obtain the effect of the present invention. Here it is preferred that the top anti-reflection coating be formed thickly enough to cover the whole resist layer. On the other hand, however, it is also preferred not to thicken the coating more than necessary for fear that the anti-reflection coating unfavorably absorbs light to increase the needed amount of exposure. Accordingly, the solid content in the composition of the present invention is generally 0.5 to 5 wt.%, preferably 1 to 4 wt.%, based on the total weight of the composition.

The composition according to the present invention may further contain other additives, if necessary. Examples of the additives include colorants such as dyes, curing agents capable of crosslinking or hardening polymers, and acids or basic compounds serving as pH adjusters.

The composition of the present invention for forming a top anti-reflection coating can be used in the same manner as the conventional one. In other words, it is unnecessary to drastically change the production process even if the composition of the present invention is adopted. In the following description, a pattern formation method employing the composition of the present invention is concretely explained.

First, a substrate such as a silicon or glass substrate, which may be pretreated, if necessary, is coated with a resist composition by a known coating method such as spin-coating, to form a resist composition layer. Before the resist composition is applied, a bottom anti-reflection coating may be previously provided on the substrate. The bottom anti-reflection coating can improve the sectional shape and the exposure margin in cooperation with the top anti-reflection coating formed from the composition of the present invention.

In the pattern formation method of the present invention, any known resist composition can be used. The resist composition used in the present invention may be a positive- or negative-working one. Examples of the positive-working resist composition include: a composition comprising quinonediazide photosensitive material and alkali-soluble resin, and a chemically amplified resist composition. Examples of the negative-working resist composition include: a composition comprising photosensitive group-containing polymer such as polyvinyl cinnamate, a composition comprising aromatic azide compound, a composition comprising cyclized rubber and azide compound such as bisazide compound, a composition comprising diazo resin, a photopolymerizable composition comprising addition-polymerizable unsaturated compound, and a chemically amplified negative-working resist composition.

Examples of the quinonediazide photosensitive material contained together with alkali-soluble resin in the above composition include: 1,2-benzoquinonediazide-4-sulfonic acid, 1,2-naphtoquinonediazide-4-sulfonic acid, 1,2-naphtoquinonediazide-5-sulfonic acid, and esters or amides thereof. Examples of the alkali-soluble resin include: novolac resin, polyvinylphenol, polyvinyl alcohol, and copolymers of acrylic acid or methacrylic acid. The novolac resin is preferably produced from one or more phenols such as phenol, o-cresol, m-cresol, p-cresol and xylenol in combination with one or more aldehydes such as formaldehyde and paraformaldehyde.

As for the chemically amplified resist composition, either a positive- or negative-working one can be used in the pattern formation method of the present invention. The chemically amplified resist generates an acid when exposed to radiations, and the generated acid serves as a catalyst to cause a chemical reaction by which solubility of the resist to the developer is changed in the exposed area and, as a result, a pattern can be formed. The chemically amplified resist comprises, for example, an acid-generating compound, which generates an acid when exposed to radiations, and a resin containing acid-sensitive groups, which are decomposed in the presence of the acid to form alkali-soluble groups such as phenolic hydroxyl and carboxyl. Further, there is also known a chemically amplified resist comprising an alkali-soluble resin, a cross-linking agent and an acid generator.

The resist composition layer provided on the substrate is then prebaked, for example, on a hot plate to remove the solvent and thereby to form a photoresist layer having a thickness of normally 0.1 to 5 µm, preferably 0.2 to 3 µm. The thickness of the resist pattern is properly determined according to the use and so on. Although depending upon the resist composition and the solvent thereof, the prebake temperature is normally 20 to 200°C, preferably 50 to 150°C.

On the formed resist layer, the composition of the present invention for forming a top anti-reflection coating is applied by spin-coating or the like, and then the solvent is evaporated to form a top anti-reflection coating. The top anti-reflection coating has a thickness of generally 10 to 80 nm, preferably 20 to 65 nm. The resist layer is thus covered with the top anti-reflection coating to form a composite film comprising the resist layer and the top anti-reflection coating. The top anti-reflection coating in the composite film is made of the above-described composition except the solvent, and hence comprises the aforementioned fine particles in an amount of 60 to 100 wt.% based on the total weight of the top anti-reflection coating.

After the resist composition is applied on the substrate in the above process, the composition for forming a top anti-reflection coating may be immediately spread thereon without completely drying the resist composition. In that case, the solvent of the composition for forming a top anti-reflection coating can be removed in the above-described prebaking procedure.

From the composition of the present invention, a top anti-reflection coating mainly comprising the fine particles is formed, as described above. The top anti-reflection coating thus formed can have such a low refractive index as 1.1 to 1.7, preferably 1.2 to 1.6, which has been difficult to realize by conventional anti-reflection coatings made of polymers and the like, and accordingly it can satisfyingly prevent the reflection. This effect is presumed to be given by the structure of the top anti-reflection coating comprising the fine particles.

The resist layer is then subjected to exposure through a mask, if necessary, by means of known exposure apparatus such as a high pressure mercury lamp, a metal halide lamp, an ultra high pressure mercury lamp, a KrF excimer laser, an ArF excimer laser, a soft X-ray irradiation system, and an electron beam lithography system.

After the exposure, baking treatment is carried out, if necessary, and then development such as paddle development is carried out to form a resist pattern. The resist layer is normally developed with an alkali developer. Examples of the alkali developer include an aqueous or water solution of sodium hydroxide or tetramethylammonium hydroxide (TMAH). After the development, the resist pattern is rinsed (washed) with a rinse solution, preferably, pure water.

The resist pattern obtained by the pattern formation method of the present invention is then processed according to the use. The processing can be carried out in the known manner. The fabricated resist pattern is employed as a mask for etching, plating, ion diffusion or dyeing, and is thereafter removed by peeling or by ashing, if necessary.

In the case where the top anti-reflection coating according to the present invention is used to form a pattern, it is sometimes preferred that the processing process such as etching or ashing treatment be controlled according to the sort of fine particles contained in the coating. For example, if the fine particles are made of inorganic materials such as silicon dioxide, they may remain after the etching or ashing treatment. In that case, it is often necessary to remove them. On the other hand, if fine carbon particles are used, it is advantageous that they seldom cause troubles in various processing processes even without special treatment. This is because the fine carbon particles are etched together with the resist layer in the etching treatment or are burned out in the ashing treatment.

The pattern formed by the method of the present invention can be employed for manufacture of semiconductor devices, flat panel displays (FPDs) such as liquid crystal displays, charge-coupled devices (CCDs), color filters and the like, in the same manner as that formed by the conventional method.

The present invention is further explained by use of the following Examples, but they by no means restrict embodiments of the present invention.

### Comparative Example 1

Acrylic acid (3.9 wt.%) and ethylene oxide-propylene oxide copolymer (0.1 wt.%) were added into pure water, and dissolved by stirring well. The prepared solution was spread on a silicon wafer to form a coating of 42 nm thickness. The refractive index of the sample thus formed was measured at 193 nm, 248 nm, 365 nm and 633 nm by means of an ellipsometer (VUV-302 [tradename], manufactured by J.A. Woollam Co., Inc.). The results were as set forth in Table 1.

### Examples 1 to 5

The contents in the solution of Comparative Example 1 were modified, and carbon black having a mean particle size of 52.4 nm was added therein to prepare compositions for top anti-reflection coating. The components of each composition were as set forth in Table 1. Each composition was then coated on a silicon wafer, and the thickness and refractive index of the formed coating were measured in the same manner as in Comparative Example 1. The results were as set forth in Table 1.

**Table 1**

| | | Com. 1 | Ex. 1 | Ex. 2 | Ex. 3 | Ex. 4 | Ex. 5 |
|---|---|---|---|---|---|---|---|
| Components (wt.%) | Carbon black | 0.0 | 0.8 | 1.6 | 2.4 | 3.2 | 4.0 |
| | Acrylic acid | 4.0 | 0.3 | 2.4 | 1.6 | 0.8 | 0.0 |
| | EO/PO copolymer* 1 | 0.1 | 0.1 | 0.1 | 0.1 | 0.1 | 0.0 |
| | Pure water | 95.9 | 98.8 | 95.9 | 95.9 | 95.9 | 96.0 |
| Thickness (nm) | | 42 | 45 | 39 | 44 | 48 | 44 |
| Refractive index | 193nm | 1.70 | 1.44 | 1.40 | 1.36 | 1.34 | 1.14 |
| | 248nm | 1.57 | 1.40 | 1.41 | 1.40 | 1.37 | 1.30 |
| | 365nm | 1.55 | 1.44 | 1.52 | 1.58 | 1.60 | 1.55 |
| | 633nm | 1.52 | 1.52 | 1.70 | 1.78 | 1.94 | 1.85 |

| | | | | | | | |
|---|---|---|---|---|---|---|---|
| * 1 : ethylene oxide-propylene oxide copolymer | | | | | | | |

### Comparative Example 2

Ethylene oxide-propylene oxide copolymer (4 wt.%) was added and dissolved by stirring well. The prepared solution was spread on a silicon wafer to form a coating of 42 nm thickness. The refractive index of the sample thus formed was measured at 193 nm, 248 nm, 365 nm and 633 nm by means of an ellipsometer (VUV-302 [tradename], manufactured by J.A. Woollam Co., Inc.). The results were as set forth in Table 2.

The contents in the solution of Comparative Example 2 were modified, and fine diamond particles having a mean particle size of 13 nm were added therein to prepare compositions for top anti-reflection coating. The components of each composition were as set forth in Table 2. Each composition was then coated on a silicon wafer, and the thickness and refractive index of the formed coating were measured in the same manner as in Comparative Example 2. The results were as set forth in Table 2.

**Table 2**

| | | Com. 2 | Ex. 6 | Ex. 7 | Ex. 8 | Ex. 9 |
|---|---|---|---|---|---|---|
| Components (wt.%) | Fine diamond particles | 0.0 | 2.0 | 2.0 | 3.0 | 4.0 |
| | EO/PO copolymer* ¹ | 4.0 | 2.0 | 2.0 | 1.0 | 0.0 |
| | Pure water | 96.0 | 96.0 | 96.0 | 96.0 | 96.0 |
| Thickness (nm) | | 42 | 39 | 44 | 48 | 44 |
| Refractive index | 193nm | n/a * ² | 1.50 | 1.46 | 1.32 | 1.14 |
| | 248nm | n/a | 1.50 | 1.48 | 1.40 | 1.30 |
| | 365nm | n/a | 1.64 | 1.64 | 1.63 | 1.55 |
| | 633nm | n/a | 1.79 | 1.85 | 1.88 | 1.85 |
| Absorption coefficient | 193nm | n/a | 0.092 | 0.133 | 0.207 | 0.242 |
| | 248nm | n/a | 0.205 | 0.292 | 0.460 | 0.496 |
| | 365nm | n/a | 0.152 | 0.245 | 0.320 | 0.370 |
| | 633nm | n/a | 0.053 | 0.113 | 0.188 | 0.194 |

| | | | | | | |
|---|---|---|---|---|---|---|
| * 1 : ethylene oxide - propylene oxide copolymer * 2 : The coating was too unstable to measure. | | | | | | |

The coating of Comparative Example 2, in which the fine diamond particles were not contained, had an uneven surface since the polymer coagulated inhomogeneously. Accordingly, it was impossible to measure the refractive index and transmittance of the coating. In contrast, the compositions of Examples 6 to 9, in which the fine diamond particles were contained, formed even coatings since the fine particles were combined with each other.

### Comparative Example 3 and Examples 10 to 16

Fine SiO₂ particles having a mean particle size of 12 nm, a fluorinated polymer which had carboxyl at the terminal and which was represented by the formula of -(CF₂CFR)ₙ- (in which R is a straight-chain fluorine-substituted alkyl group having 3 carbon atoms, and n is a number indicating the polymerization degree), and an alkylsulfonic acid having an alkyl chain of 13 to 18 carbon atoms were added in pure water in the amounts shown in Table 3, and stirred well to prepare compositions for top anti-reflection coating. Each composition was then spin-coated on a silicon wafer at 2500 rpm, to obtain a sample. The refractive index of each sample thus formed was measured at 193 nm, 248 nm, 365 nm and 633 nm by means of an ellipsometer (VUV-302 [tradename], manufactured by J. A. Woollam Co., Inc.). The results were as set forth in Table 3.

**Table 3**

| | | Com. 3 | Ex. 10 | Ex. 11 | Ex. 12 | Ex. 13 | Ex. 14 | Ex. 15 | Ex. 16 |
|---|---|---|---|---|---|---|---|---|---|
| Components (wt.%) | SiO₂ particles | 0.0 | 1.0 | 2.0 | 3.0 | 3.4 | 3.6 | 3.8 | 4.0 |
| | Fluorinated polymer | 4.0 | 3.0 | 2.0 | 1.0 | 0.6 | 0.4 | 0.2 | 0.0 |
| | Alkylsulfonic acid | 0.1 | 0.1 | 0.1 | 0.1 | 0.1 | 0.1 | 0.1 | 0.1 |
| | Pure water | 95.9 | 95.9 | 95.9 | 95.9 | 95.9 | 95.9 | 95.9 | 95.9 |
| Thickness (nm) | | 42 | 49 | 55 | 64 | 62 | 65 | 63 | 67 |
| Refractive index | 193nm | 1.45 | 1.49 | 1.49 | 1.43 | 1.44 | 1.39 | 1.39 | 1.36 |
| | 248nm | 1.41 | 1.41 | 1.39 | 1.36 | 1.35 | 1.34 | 1.33 | 1.31 |
| | 365nm | 1.38 | 1.39 | 1.38 | 1.36 | 1.36 | 1.35 | 1.35 | 1.33 |
| | 633nm | 1.37 | 1.38 | 1.37 | 1.33 | 1.27 | 1.31 | 1.31 | 1.29 |

The above results indicate that the top anti-reflection coatings formed from the compositions of the present invention,
in which the fine particles were contained, had refractive indexes of nearly the same or lower than that formed from the conventional composition (Comparative Example 3), in which only the fluorinated polymer conventionally used was incorporated.

### Comparative Example 4 and Examples 17 to 23

Fine SiO₂ particles having a mean particle size of 12 nm, acrylic acid, and an alkylsulfonic acid having an alkyl chain of 13 to 18 carbon atoms were added in pure water in the amounts shown in Table 4, and stirred well to prepare compositions for top anti-reflection coating. Each composition was then spin-coated on a silicon wafer at 2500 rpm, to obtain a sample. The refractive index of each sample thus formed was measured at 193 nm, 248 nm, 365 nm and 633 nm by means of an ellipsometer (VUV-302 [tradename], manufactured by J.A. Woollam Co., Inc.). The results were as set forth in Table 4.

**Table 4**

| | | Com. 4 | Ex. 17 | Ex. 18 | Ex. 19 | Ex. 20 | Ex. 21 | Ex. 22 | Ex. 23 |
|---|---|---|---|---|---|---|---|---|---|
| Components (wt.%) | SiO₂ particles | 0.0 | 0.8 | 2.3 | 6.0 | 2.0 | 3.4 | 3.7 | 4.0 |
| | Acrylic acid | 2.5 | 2.4 | 2.3 | 2.0 | 0.6 | 0.4 | 0.2 | 0.0 |
| | Alkylsulfonic acid | 0.1 | 0.1 | 0.1 | 0.1 | 0.0 | 0.0 | 0.0 | 0.0 |
| | Pure water | 97.4 | 96.7 | 95.3 | 91.9 | 97.5 | 96.2 | 96.1 | 96.0 |
| Thickness (nm) | | 37 | 45 | 62 | 119 | 53 | 56 | 62 | 65 |
| Refractive index | 193nm | 1.70 | 1.66 | 1.61 | 1.55 | 1.49 | 1.45 | 1.39 | 1.36 |
| | 248nm | 1.57 | 1.56 | 1.56 | 1.48 | 1.38 | 1.36 | 1.33 | 1.30 |
| | 365nm | 1.55 | 1.55 | 1.50 | 1.42 | 1.40 | 1.37 | 1.34 | 1.32 |
| | 633nm | 1.52 | 1.50 | 1.48 | 1.42 | 1.36 | 1.34 | 1.30 | 1.28 |

### Comparative Example 5 and Example 24

A resist composition (DX5240P [tradename], manufactured by AZ Electronic Materials (Japan) K.K.) was spin-coated on a silicon wafer, and then heated at 90°C for 60 seconds to form a resist layer having a thickness of 400 to 505 nm (Comparative Example 5). On the resist layer, a composition comprising 2 wt.% of fine diamond particles having a mean particle size of 13 nm, 0.1 wt.% of ethylene oxide-propylene oxide copolymer and water as solvent was spin-coated to form a top anti-reflection coating of 30 nm thickness (Example 24).
The resist layer was then subjected to exposure by means of a KrF excimer stepper (FPA-3000EX [tradename], manufactured by Canon Inc.), and heated at 120°C for 60 seconds. Thereafter, development was carried out with 2.38 wt.% aqueous solution of tetramethylammonium hydroxide, and the energy threshold (hereinafter, referred to as "Eth") was measured. Here the "Eth" means sensitivity that the resist layer was required to have in order that the layer having been exposed to light was completely removed to bare the substrate in the development. The measured values of Eth were then plotted against the thickness to obtain a curve showing decreasing amplitude. Since the curve indicated interference of light on the layer surface, the effect of the anti-reflection coating was estimated from the decreasing rate of the amplitude.
As a result, the decreasing rate of Example 24 was reduced by 61% as compared with that of Comparative Example 5. Accordingly, it was confirmed that the anti-reflection coating according to the present invention functioned well as an anti-reflection coating.

### Comparative Example 6 and Example 25

A resist composition (DX5240P [tradename], manufactured by AZ Electronic Materials (Japan) K.K.) was spin-coated on a silicon wafer, and then heated at 90°C for 60 seconds to form a resist layer having a thickness of 520 to 610 nm (Comparative Example 6). On the resist layer, a composition comprising 2.2 wt.% of fine silicon dioxide particles having a mean particle size of 12 nm, 0.24 wt.% of a fluorinated polymer which had carboxyl at the terminal and which was represented by the formula of -(CF₂CFR)ₙ- (in which R is a straight-chain fluorine-substituted alkyl group having 3 carbon atoms, and n is a number indicating the polymerization degree), 0.06 wt.% of an alkylsulfonic acid (A-32-FW [tradename], manufactured by Takemoto Oil & Fat Co., Ltd.) and water as solvent was spin-coated to form a top anti-reflection coating of 45 nm thickness (Example 25).
The procedure of Comparative Example 6 was repeated to measure the Eth. As a result, the decreasing rate of Example 25 was reduced by 55% as compared with that of Comparative Example 6. Accordingly, it was confirmed that the anti-reflection coating according to the present invention functioned well as an anti-reflection coating.

## Claims

1. A composition for forming a top anti-reflection coating, **characterized by** comprising fine particles having a mean particle size of 1 to 100 nm and a solvent.

2. The composition for forming a top anti-reflection coating according to claim 1, wherein content of said fine particles is in an amount of 60 to 100 wt.% based on the solid content of said composition.

3. The composition for forming a top anti-reflection coating according to claim 1 or 2, wherein said solid content is in the range of 0.5 to 5 wt.% based on the total weight of said composition.

4. The composition for forming a top anti-reflection coating according to any of claims 1 to 3, **characterized by** further comprising a water-soluble polymer.

5. The composition for forming a top anti-reflection coating according to claim 4, wherein said water-soluble polymer is a fluorinated polymer or an acrylic polymer.

6. The composition for forming a top anti-reflection coating according to any of claims 1 to 5, **characterized by** furthermore comprising a surfactant.

7. The composition for forming a top anti-reflection coating according to any of claims 1 to 6, wherein said fine particles are fine carbon particles or fine silicon dioxide particles.

8. A pattern formation method comprising the steps of:
coating a substrate with a resist composition to form a resist layer,
spreading on said resist layer a composition for forming a top anti-reflection coating, said composition comprising fine particles having a mean particle size of 1 to 100 nm and a solvent; and then drying the spread composition,
imagewise exposing said resist layer to light, and
developing the resist layer.

9. A composite film comprising a resist layer and a top anti-reflection coating with which the top surface of said resist layer is covered, wherein said top anti-reflection coating contains fine particles having a mean particle size of 1 to 100 nm in an amount of 60 to 100 wt.% based on the total weight of said top anti-reflection coating.
